Europäisches Patentamt

European Patent Office

Office européen des brevets

(11) Veröffentlichungsnummer: **0 083 801**
A2

(12) **EUROPÄISCHE PATENTANMELDUNG**

(21) Anmeldenummer: 82112074.8

(22) Anmeldetag: 28.12.82

(51) Int. Cl.³: **H 01 L 29/78**
H 01 L 27/08, H 01 L 27/06

(30) Priorität: 12.01.82 DE 3200660

(43) Veröffentlichungstag der Anmeldung:
20.07.83 Patentblatt 83/29

(84) Benannte Vertragsstaaten:
CH DE FR GB IT LI SE

(71) Anmelder: SIEMENS AKTIENGESELLSCHAFT
Berlin und München Wittelsbacherplatz 2
D-8000 München 2(DE)

(72) Erfinder: Tihanyi, Jenö, Dr. Ing.
Wolfratshauser Strasse 71
D-8000 München 71(DE)

(54) MIS-Feldeffekttransistor mit Ladungsträgerinjektion.

(57) Der Durchlaßwiderstand von hochsperrenden MIS-FET ist relativ groß. Er läßt sich durch eine Injektorzone (6) herabsetzen, die Ladungsträger in die Drainzone (1) emittiert und damit quasi eine Erhöhung der Dotierung bewirkt. Die Injektorzone ist über die Source-Drainstrecke eines weiteren MIS-FET (10) mit der Drainzone (1) des MIS-FET verbunden. Die Gateanschlüsse beider MIS-FET sind ebenfalls miteinander verbunden. In integrierter Form haben beide MIS-FET eine gemeinsame Gateelektrode (18). Die Injektorzone (6) liegt dabei unter der Gateelektrode und zwischen beiden MIS-FET.

FIG 1

EP 0 083 801 A2

SIEMENS AKTIENGESELLSCHAFT
Berlin und München

Unser Zeichen

VPA

82 P 1 0 0 6 E

## MIS-Feldeffekttransistor mit Ladungsträgerinjektion

Die Erfindung bezieht sich auf einen MIS-Feldeffekttransistor mit einem Halbleitersubstrat vom ersten Leitungstyp, mit mindestens einer in einer der Oberflächen des Substrats eingebetteten Kanalzone vom entgegengesetzten Leitungstyp und mit einer in der Kanalzone eingebetteten Sourcezone vom ersten Leitungstyp, mit einer an diese Oberfläche angrenzenden Drainzone und mit einer mit der anderen Oberfläche verbundenen Drainelektrode, mit mindestens einer Gateelektrode, die auf einer auf der einen Oberfläche angebrachten Isolierschicht sitzt, und mit mindestens einer in die eine Oberfläche eingebetteten Injektorzone vom entgegengesetzten Leitungstyp mit einem pn-Übergang, der unter der Gateelektrode liegt.

Ein solcher Feldeffekttransistor (FET) ist bereits in der älteren deutschen Anmeldung P 31 03 444.6 beschrieben worden. MIS-FET haben mit steigender maximaler Sperrspannung einen stark ansteigenden Durchlaßwiderstand $R_{on}$, was dazu führt, daß $R_{on}$ für maximale Sperrspannungen oberhalb etwa 300 V größer als bei für die gleiche Sperrspannung ausgelegten Bipolartransistoren ist, wenn keine besonderen Maßnahmen ergriffen werden. Durch die Injektorzone werden nun Ladungsträger in die Drainzone emittiert, was eine erhöhte Konzentration von Ladungsträgerpaaren im stromführenden Bereich verursacht. Dies kommt einer Erhöhung der Dotierung und damit einer Verminderung des $R_{on}$ gleich. Beim beschriebenen MIS-FET ist die Injektorzone mit der Gateelektrode des MIS-FET verbunden. Da die Injektorzone einen bestimmten

Hab 1 Dx / 07.01.1982

Strom zieht, wird das Steuergerät, z. B. eine VLSI-Schaltung oder ein Mikroprozessor, leistungsmäßig belastet. Dies ist für viele Zwecke jedoch unerwünscht.

Der Erfindung liegt die Aufgabe zugrunde, einen MIS-FET der genannten Gattung so weiterzubilden, daß eine leistungsmäßige Belastung des Steuergerätes weitgehend vermieden wird.

Die Erfindung ist dadurch gekennzeichnet, daß die Injektorzone über die Source-Drainstrecke eines weiteren MIS-FET mit der Drainzone des ersten MIS-FET verbunden ist und daß die Gateelektrode des weiteren MIS-FET elektrisch mit der Gateelektrode des ersten MIS-FET verbunden ist.

Weiterbildungen der Erfindung sind Gegenstand der Unteransprüche.

Die Erfindung wird an Hand einiger Ausführungsbeispiele in Verbindung mit den Fig. 1 bis 5 näher erläutert. Es zeigen:

Fig. 1 den Schnitt durch einen MIS-FET mit der dazugehörigen Schaltung gemäß einem ersten Ausführungsbeispiel,

Fig. 2 den Schnitt durch einen MIS-FET gemäß einem zweiten Ausführungsbeispiel,

Fig. 3 den Schnitt durch einen MIS-FET gemäß einem dritten Ausführungsbeispiel,

Fig. 4 die Aufsicht auf den Halbleiterkörper nach Fig. 3, bei dem der besseren Übersichtlichkeit halber sämtliche Elektroden fortgelassen sind und

Fig. 5 die Aufsicht auf einen MIS-FET mit einer Vielzahl von Zellen.

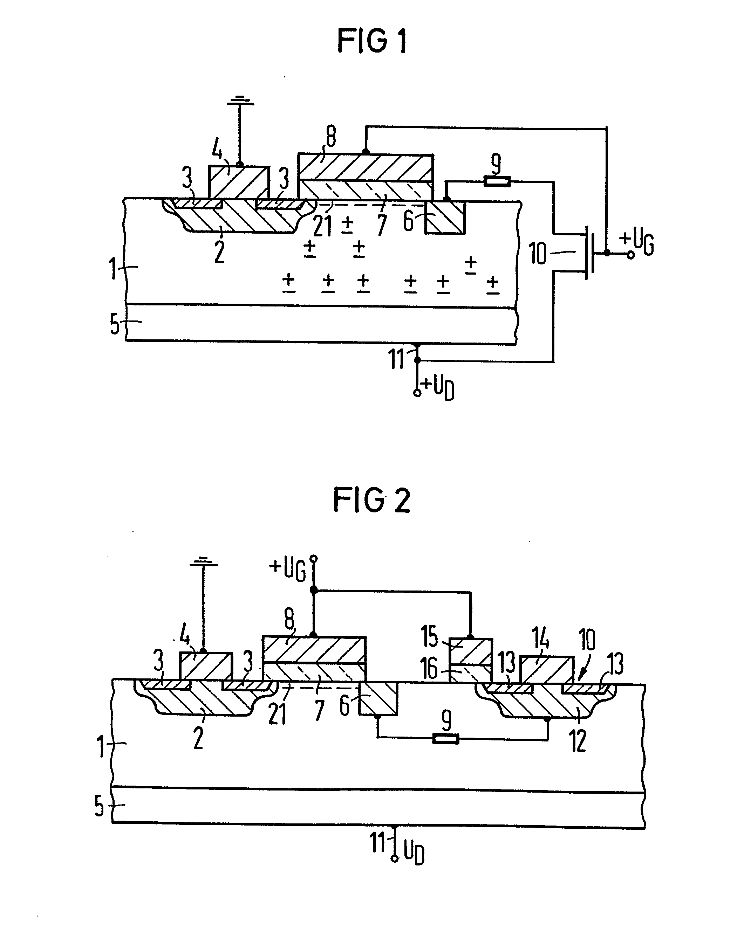

Der Halbleiterkörper des MIS-FET nach Fig. 1 hat eine erste, beispielsweise n-dotierte Zone 1, in die eine Kanalzone 2 vom entgegengesetzten Leitungstyp eingebettet ist. In die Kanalzone 2 ist eine Sourcezone 3 vom ersten Leitungstyp eingebettet. Kanalzone 2 und Sourcezone 3 sind durch einen Sourcekontakt 4 elektrisch miteinander verbunden. Die Zone 1 ist gegenüber den anderen Zonen 2 und 3 relativ schwach dotiert; sie ist das Substrat für die obengenannten Zonen. Sie dient als Drainzone und ist über eine stark n-dotierte Zwischenzone 5 mit einem Drainkontakt 11 verbunden.

In derjenigen Oberfläche, in der die Kanalzone 2 eingebettet ist, ist auch eine Injektorzone 6 angeordnet. Auf dieser Oberfläche sitzt eine durch eine Isolierschicht 7 gegen die Oberfläche isolierte Gateelektrode 8. Diese reicht auf der Seite der Injektorzone 6 mindestens bis zum an die Oberfläche tretenden Teil des pn-Übergangs zwischen der Injektorzone 6 unter der Drainzone 1 oder überlappt die Injektorzone 6. Auf der anderen Seite überlappt die Gateelektrode 8 denjenigen an die Oberfläche des Halbleiterkörpers tretenden Teil der Kanalzone 2, der nicht von der Sourceelektrode 4 kontaktiert ist. Die Injektorzone 6 ist, eventuell über einen Widerstand 9, mit dem Sourceanschluß eines weiteren MIS-FET 10 verbunden, dessen Drainelektrode elektrisch mit dem Drainanschluß 11 verbunden ist. Die Gateelektrode des weiteren MIS-FET 10 ist mit der Gateelektrode 8 verbunden.

Liegt an der Drainelektrode 11 die Spannung $+U_D$, an der Sourceelektrode 4 Massepotential und sind beide MIS-FET vom n-Kanaltyp, so wird der MIS-FET und der weitere MIS- FET 10 durch eine positive Gatespannung $+U_G$ leitend gesteuert. Dabei wird unter der Gateelektrode 8 eine Akkumulationsschicht 21 aus negativen Ladungsträgern gebil- det. Die Konzentration an Ladungsträgern ist hier so

0083801

stark, daß die Akkumulationsschicht wenigstens angenähert ohmschen Charakter hat. Damit wird das Potential in der Umgebung der Injektorzone 6 abgesenkt und die Injektorzone erhält Strom von der Drainelektrode 11 über den weiteren MIS-FET 10. Sie emittiert damit positive Ladungsträger in die Drainzone 1. Dies führt wiederum zu einer Anreicherung von negativen Ladungsträgern in diesem Bereich. Insgesamt wird hier also die Dichte der Ladungsträger erhöht, was einer Verminderung des Durchlaßwiderstandes $R_{on}$ gleichkommt.

Anstelle des diskreten MIS-FET 10 nach Fig. 1 kann der weitere MIS-FET, wie in Fig. 2 dargestellt, auch in den Halbleiterkörper des ersten MIS-FET integriert werden. Die Kanalzone 12 des weiteren MIS-FET ist vom der Drainzone 1 entgegengesetzten Leitungstyp. In die Kanalzone ist eine Sourcezone 13 vom ersten Leitungstyp eingebettet. Sourcezone 13 und Kanalzone 12 sind durch einen Kontakt 14 miteinander verbunden, der einen Nebenschluß zwischen diesen Zonen bildet. Der MIS-FET 10 wird durch eine Gateelektrode 15 gesteuert, die auf einer Isolierschicht 16 angeordnet ist. Beide Teile sitzen über einem an die Oberfläche der Drainzone tretenden Teil der Kanalzone 12, die nicht durch den Kontakt 14 kontaktiert ist. Die Gateelektroden 15 und 8 sind elektrisch miteinander verbunden. Der Kontakt 14 ist elektrisch nicht angeschlossen, er driftet auf einem durch die elektrischen Potentialverhältnisse im Halbleiterkörper vorgegebenen Potential.

Sind beide MIS-FET vom n-Kanaltyp (Zonenfolge von oben $n^+p^+n^-n^+$), werden beide MIS-FET durch eine positive Gatespannung $+U_G$ leitend gesteuert. Dabei bildet sich unter der Gateelektrode 8 wieder eine Akkumulationsschicht 21 aus, die das Potential in der Umgebung der Injektorzone 6 absenkt. Damit fließt ein Strom vom Drainanschluß 11 durch den weiteren MIS-FET 10 auf dem Weg über seine Sourcezone 13, den Kontakt 14, die Kanalzone 12, den wahlweise vorgesehenen Widerstand 9 zur Injektorzone 6. Dieser emittiert dann positive Ladungsträger, was zu der in Verbindung mit Fig. 1 beschriebenen Konzentrationserhöhung von Ladungsträgerpaaren in der Drainzone 1 führt.

Der wahlweise vorgesehene Widerstand 9 kann ein externer Widerstand sein, er kann durch eine auf der Oberfläche liegende Leiterbahn gebildet sein oder durch eine in den Halbleiterkörper integrierte Hilfszone vom gleichen Leitungstyp wie die Injektorzone 6 und die Kanalzone 12.

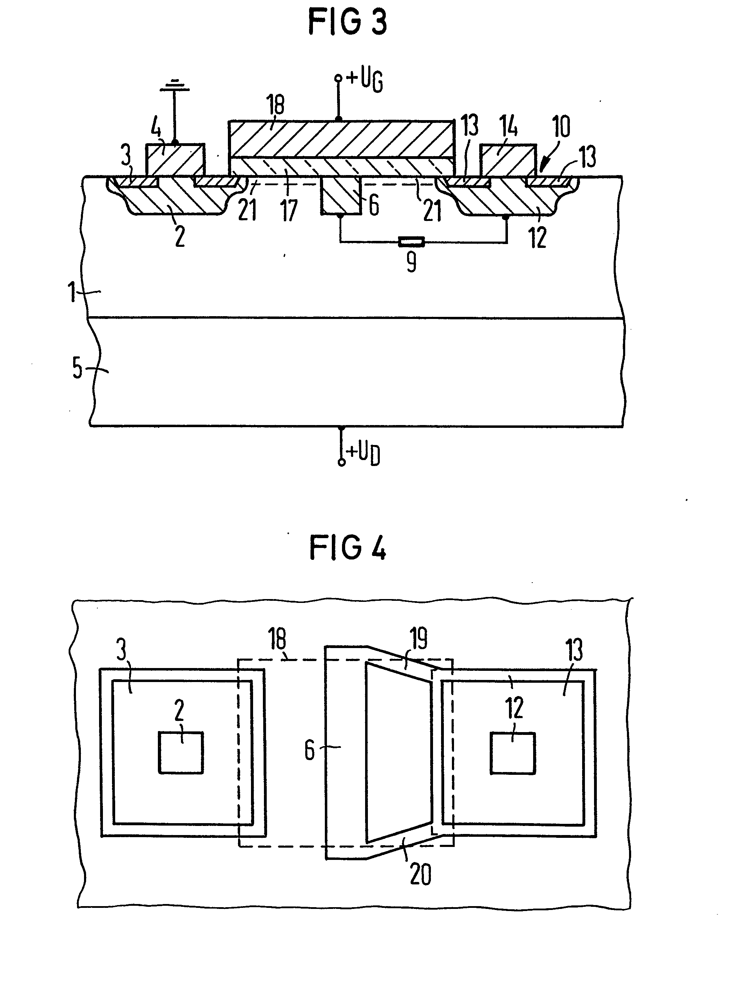

Das Ausführungsbeispiel nach Fig. 3 unterscheidet sich von dem nach Fig. 2 im wesentlichen dadurch, daß beide MIS-FET durch eine gemeinsame Gateelektrode 18 gesteuert sind. Diese ist auf einer Isolierschicht 17 angeordnet. Damit ein Parallelschalten beider MIS-FET vermieden wird, ist die Injektorzone 6 zwischen beiden MIS-FET angeordnet. Damit wird die Akkumulationsschicht 21 unterbrochen, so daß keine ohmsche Verbindung zwischen den Sourcezonen 3 und 13 zustande kommen kann.

Der in Fig. 3 symbolisch dargestellte Widerstand 9 bzw. die elektrische Verbindung kann, wie bereits in Verbindung mit Fig. 2 erwähnt, durch eine oder mehrere Hilfszonen entsprechender Dotierung gebildet werden, die gleichen Leitungstyp wie die Injektorzone und die Kanalzonen haben. In Fig. 4 ist eine mögliche Ausführungsform gezeigt. Dort ist die Kanalzone 12 durch zwei Stege 19, 20 mit der Injektorzone 6 verbunden. Die Injektorzone ist dabei breiter als die Gateelektrode 18, deren Umrisse in der Figur gestrichelt sind. Damit wird die Inversionsschicht 21 vollständig unterbrochen und eine ohmsche Verbindung zwischen den beiden MIS-FET verhindert.

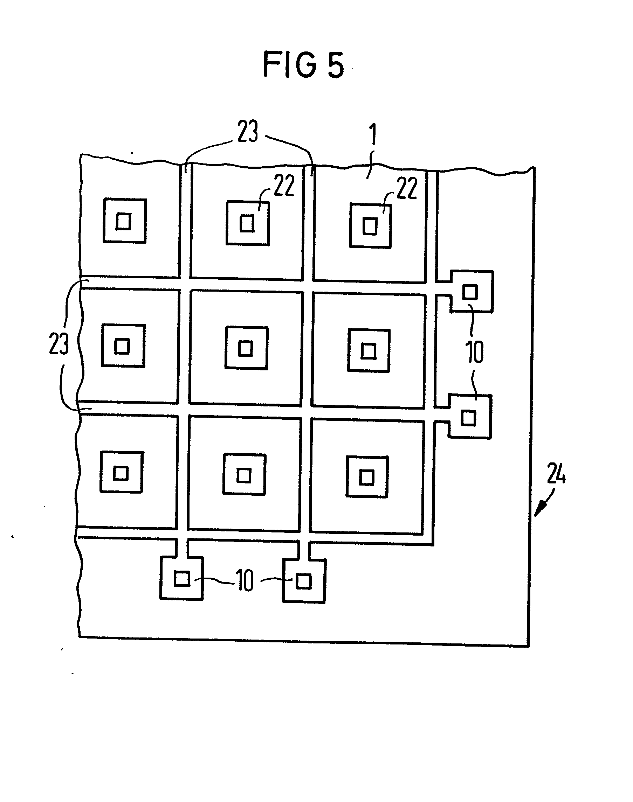

Die dargestellten Ausführungsbeispiele zeigen jeweils Ausschnitte aus großflächigen Halbleiterkörpern. Für den praktischen Betrieb werden eine Vielzahl von ersten MIS-FET bzw. weiteren MIS-FET einander parallelgeschaltet. Ein Ausführungsbeispiel dafür ist in Fig. 5 dargestellt. Die Source- und Gateelektroden sind der besseren Übersichtlichkeit halber weggelassen. Die weiteren MIS-FET 10 liegen am Rand eines Halbleiterchips 24, auf dem eine Vielzahl von ersten MIS-FET-Zellen 22 angeordnet sind. Mit den Kanalzonen der MIS-FET-Zellen 10 sind Stege 23 gleichen Leitungstyps verbunden. Diese können ein regelmäßiges Netz bilden und liegen zur elektrischen Trennung der Zellen 10 und 22 immer zwischen diesen.

5 Figuren
7 Patentansprüche

Patentansprüche

1. MIS-FET mit einem Halbleitersubstrat vom ersten Leitungstyp, mit mindestens einer in einer der Oberflächen des Substrats eingebetteten Kanalzone (2) vom entgegengesetzten Leitungstyp und mit einer in der Kanalzone eingebetteten Sourcezone (3) vom ersten Leitungstyp, mit einer an diese Oberfläche angrenzenden Drainzone (1) und mit einer mit der anderen Oberfläche verbundenen Drainelektrode (11), mit mindestens einer Gateelektrode (8), die auf einer auf der einen Oberfläche angebrachten Isolierschicht (7) sitzt, und mit mindestens einer in die eine Oberfläche eingebetteten Injektorzone (6) vom entgegengesetzten Leitungstyp mit einem pn-Übergang, der unter der Gateelektrode liegt, d a d u r c h   g e - k e n n z e i c h n e t ,   daß die Injektorzone (6) über die Source-Drainstrecke eines weiteren MIS-FET (10) mit der Drainzone (1) des ersten MIS-FET verbunden ist und daß die Gateelektrode des weiteren MIS-FET elektrisch mit der Gateelektrode (8) des ersten MIS-FET verbunden ist.

2. MIS-FET nach Anspruch 1, d a d u r c h   g e - k e n n z e i c h n e t ,   daß der weitere MIS-FET (10) eine in die eine Oberfläche des Substrats eingebettete Kanalzone (12) vom entgegengesetzten Leitungstyp und eine in die Kanalzone eingebettete Sourcezone (13) vom ersten Leitungstyp aufweist, daß der weitere MIS-FET einen Sourcekontakt (14) hat, der einen Nebenschluß zwischen der Sourcezone und der Kanalzone des weiteren MIS-FET bildet, daß die Gateelektrode (15) des weiteren MIS-FET in lateralem Abstand von der Gateelektrode (8) des ersten MIS-FET und in lateralem Abstand von der Injektorzone (6) angeordnet ist, und daß der Sourcekontakt (14) des weiteren MIS-FET elektrisch mit der Injektorzone (6) verbunden ist.

3. MIS-FET nach Anspruch 1, d a d u r c h  g e -
k e n n z e i c h n e t , · daß der weitere MIS-FET (10)
eine in die eine Oberfläche des Substrats eingebettete
Kanalzone (12) von entgegengesetztem Leitungstyp und eine in die Kanalzone eingebettete Sourcezone (13) vom ersten Leitungstyp aufweist, daß der weitere MIS-FET einen
Sourcekontakt hat, der einen Nebenschluß zwischen der
Sourcezone und der Kanalzone des weiteren MIS-FET bildet, daß der erste und der weitere MIS-FET eine gemeinsame Gateelektrode (18) haben, daß die Injektorzone (6)
zwischen erstem und weiterem MIS-FET liegt und in ihrer
Breite derart bemessen ist, daß eine unter der Gateelektrode gebildete Akkumulationsschicht (21) zwischen den
Kanalzonen (2, 12) der beiden MIS-FET vollständig unterbrochen ist, und daß die Sourcezone (13) des weiteren
MIS-FET elektrisch mit der Injektorzone (6) verbunden
ist.

4. MIS-FET nach Anspruch 2 oder 3, d a d u r c h
g e k e n n z e i c h n e t ,  daß die Sourcezone (13)
des weiteren MIS-FET (10) über seine Kanalzone (12) und
durch mindestens eine in die eine Oberfläche des Substrats eingebettete Hilfszone (9, 19) gleichen Leitungstyps mit der Injektorzone (6) verbunden ist.

5. MIS-FET nach Anspruch 4, d a d u r c h  g e -
k e n n z e i c h n e t ,  daß die Hilfszone (9, 19)
mindestens so hoch wie die Injektorzone (6) und die Kanalzonen (2, 12) dotiert ist.

6. MIS-FET nach einem der Ansprüche 1 bis 5, d a -
d u r c h  g e k e n n z e i c h n e t ,  daß auf ein
und demselben Halbleiterchip (24) mehrere erste MIS-FET-
Zellen (22) und mehrere weitere MIS-FET-Zellen (10) angeordnet sind, und daß die Hilfszone die Form von untereinander zusammenhängenden Stegen (23) hat.

7. MIS-FET nach Anspruch 6, d a d u r c h   g e - k e n n z e i c h n e t ,  daß die weiteren MIS-FET-Zellen (10) am Rand des Halbleiterchips (24) angeordnet sind, und daß die Stege (23) ein regelmäßiges Netz bilden.

FIG 1

FIG 2

## FIG 3

## FIG 4

0083801

## FIG 5